# EUROPÄISCHE PATENTSCHRIFT

(11) **EP 1 695 104 B1**
(45) Veröffentlichungstag und Bekanntmachung des Hinweises auf die Patenterteilung: **29.04.2009**
(21) Anmeldenummer: 04820450.7
(22) Anmeldetag: 10.11.2004
(51) Int. Cl.: G01R 31/40, G01R 19/165, G01R 31/34, B60L 3/00, H02M 7/00

(54) **VERFAHREN UND ANORDNUNG ZUR PRÜFUNG EINER LEISTUNGSENDSTUFE**
METHOD AND ASSEMBLY FOR TESTING A POWER OUTPUT STAGE
PROCEDE ET ENSEMBLE POUR TESTER UN ETAGE DE SORTIE DE PUISSANCE

(30) Priorität: 17.12.2003 DE 10359235
(43) Veröffentlichungstag der Anmeldung: 30.08.2006
(73) Patentinhaber: Continental Automotive GmbH, 30165 Hannover (DE)
(72) Erfinder: BAY, Wolfgang, 65936 Frankfurt (DE); HENNINGER, Michael, 65779 Kelkheim (DE); SADER, Frank, 60487 Frankfurt (DE)
(86) Internationale Anmeldenummer: PCT/EP2004/052903
(87) Internationale Veröffentlichungsnummer: WO 2005/059580

(56) Entgegenhaltungen:
- DE-A1- 4 135 287
- US-B1- 6 236 227
- US-B1- 6 381 110
- PATENT ABSTRACTS OF JAPAN Bd. 017, Nr. 669 (P-1657), 9. Dezember 1993 (1993-12-09) -& JP 05 223906 A (MITSUBISHI ELECTRIC CORP), 3. September 1993 (1993-09-03)
- Y.V.V.S. MURTY, G.K. DUBEY, R.M.K. SINHA: "Fault Diagnosis in Three-Phase Thyristor Converters Using Microprocessor" IEEE TRANSACTIONS ON INDUSTRY APPLICATIONS, Dezember 1984 (1984-12), Seiten 1490-1496, XP002319641 NEW YORK

## Beschreibung

Die Erfindung betrifft ein Verfahren und eine Anordnung zur Prüfung einer Leistungsendstufe, wobei die Leistungsendstufe mindestens drei aus jeweils einer Reihenschaltung eines oberen und eines unteren Halbleiterschalters bestehende und mit Betriebsspannung beaufschlagte Halbbrücken aufweist und wobei die Verbindungspunkte der Halbleiterschalter der Halbbrücken Ausgänge bilden, welche mit in Sternschaltung betriebenen Wicklungen eines mindestens dreiphasigen Motors verbunden sind.

Mit Halbleiterschaltern bestückte Leistungsendstufen werden unter anderem in Kraftfahrzeugen zur Ansteuerung von Verbrauchern, beispielsweise Gleichstrommotoren, verwendet. Durch die rasante Entwicklung von niederohmigen Leistungs-MOSFETs können auch Verbraucher im Kilowattbereich kostengünstig angesteuert werden. In Kraftfahrzeugen kann es vorkommen, dass die Leistungsendstufe und der Verbraucher räumlich voneinander getrennt angeordnet werden, wobei Kurzschlüsse der Verbraucherzuleitungen gegen Masse oder gegen Batteriespannung zu hohen Fehlerströmen führen können. Schmelzsicherungen können im Allgemeinen in diesen Stromkreisen aufgrund ihrer Toleranzen, ihrer Innenwiderstände und der hohen Nutzströme nicht eingesetzt werden. Außerdem kann infolge eines defekten MOSFETs in der Leistungsendstufe ein hoher Fehlerstrom fließen.

Aus der US-B-6236227 ist ein Verfahren zur Erkennung von Wicklungsfehlern bekannt, bei dem Spannungen an Wicklungen zwischen Sternpunkt und dem jeweiligen Phasenanschluss gemessen, mit Hilfe von Kalibratoren und eines Filters zu verarbeitet und mittels einer Summierschaltung addiert werden. Dies erfolgt bei normalem Betrieb, bei dem an den Wicklungen drei jeweils um 120° phasenversetzte Wechselspannungen anliegen. Durch einen Inverter wird ein Drehfeld erzeugt, bei dem jeweils für ein Drittel der Periodendauer Spannung anliegt.

Aufgabe der Erfindung ist es, ein Verfahren und eine Anordnung zur Prüfung einer Leistungsendstufen vorzusehen, so dass im Falle eines Kurzschlusses die Betriebsspannung abgeschaltet bzw. gar nicht erst eingeschaltet wird und somit die Leistungsendstufe und das Bordnetz vor Schäden geschützt werden.

Diese Aufgabe wird bei dem erfindungsgemäßen Verfahren dadurch gelöst, dass von einer Steuereinrichtung die Halbleiterschalter nacheinander und/öder mehrere gleichzeitig jeweils kurzzeitig in den leitenden Zustand geschaltet werden und dabei die Spannung am Sternpunkt daraufhin überprüft wird, ob sie in einem jeweils vorgegebenen Toleranzbereich liegt, und dass die Leistungsendstufe als fehlerfrei erkannt wird, wenn alle am Sternpunkt gemessenen Spannungen innerhalb des jeweiligen Toleranzbereichs liegen.

Vorzugsweise ist bei einer vorteilhaften Ausgestaltung vorgesehen, dass vor und während der Prüfungen die Betriebsspannung über eine strombegrenzende Einrichtung zugeführt wird, und dass nach Erkennen der Leistungsendstufe als fehlerfrei die Betriebsspannung ohne Strombegrenzung zugeführt wird.

Eine andere vorteilhafte Ausgestaltung besteht darin, dass während der Prüfung die Halbleiterschalter derart kurzzeitig in den leitenden Zustand geschaltet werden, dass sowohl keine Schäden auftreten als auch der Verbraucher während der Prüfung nicht oder nur unmerklich beeinflusst wird, und dass nach Erkennen der Leistungsendstufe als fehlerfrei den Halbleiterschaltern die für den normalen Betrieb vorgesehenen Ansteuerimpulse zugeführt werden. Bei den gebräuchlichen Halbleiterschaltern kann eine Einschaltzeit von kleiner als etwa 1 bis 2 ms zweckmäßig sein.

Zur Durchführung des erfindungsgemäßen Verfahrens sind nur wenige zusätzliche Widerstände und Eingänge von an den Steuereinrichtungen ohnehin vorhandenen Analog/Digital-Wandlern erforderlich. Diese stellen zusammen mit einem geeigneten Programm in der Steuereinrichtung einen oder mehrere Fensterkomparatoren dar, die auch in anderer Weise realisiert werden können.

Mit dem erfindungsgemäßen Verfahren kann der Zustand der Leistungsendstufe differenziert beurteilt werden, wobei der jeweilige Verbraucher, beispielsweise ein Motor, während der Prüfung nicht oder nur unmerklich beeinflusst wird. Die Prüfung kann automatisch vor dem jeweiligen Einschalten der Leistungsendstufe erfolgen, beispielsweise bei der Betätigung des Zündschlüssels eines Kraftfahrzeugs, oder auch während des Betriebs durchgeführt werden.

Sollte im Einzelfall die Überwachung der Spannung am Sternpunkt nicht genügen, so kann bei dem erfindungsgemäßen Verfahren vorgesehen sein, dass ferner Ausgangsspannungen der Halbbrücken auf ihre Lage innerhalb eines jeweiligen Toleranzbereichs überprüft werden.

Eine vorteilhafte Ausgestaltung des erfindungsgemäßen Verfahrens besteht darin,
- dass zunächst eine Prüfung bei nicht in den leitenden Zustand gesteuerten Halbleiterschaltern daraufhin erfolgt, ob die Spannung am Sternpunkt innerhalb eines mittleren Toleranzbereichs liegt,
- dass die oberen Halbleiterschalter kurz einzeln nacheinander und/oder mehrere gleichzeitig in den leitenden Zustand geschaltet werden und eine Prüfung daraufhin erfolgt, ob die dabei am Sternpunkt anliegenden Spannungen in einem oberen Toleranzbereich liegen, und
- dass die unteren Halbleiterschalter kurz einzeln nacheinander und/oder mehrere gleichzeitig in den leitenden Zustand geschaltet werden und eine Prüfung daraufhin erfolgt, ob die dabei am Sternpunkt anliegenden Spannungen in einem unteren Toleranzbereich liegen.

Der obere Toleranzbereich liegt dabei in der Nähe der jeweiligen Betriebsspannung - im Falle einer zur Prüfung herabgesetzten Betriebsspannung also in der Nähe dieser Spannung. Der untere Toleranzbereich liegt in der Nähe des Massepotentials.

Eine erfindungsgemäße Anordnung löst die Aufgabe dadurch, dass der Sternpunkt mit Eingängen eines Fensterkomparators verbunden ist, der an eine Steuereinrichtung angeschlossen ist, die eine Ansteuerschaltung für die Halbleiterschalter steuert, und dass die Steuereinrichtung mit einem Programm versehen ist, das die Halbleiterschalter nacheinander und/oder mehrere gleichzeitig jeweils kurzzeitig in den leitenden Zustand schaltet und dabei prüft, ob die Spannung am Sternpunkt in einem jeweils vorgegebenen Toleranzbereich liegt, wobei die Prüfung derart eingerichtet ist, dass die Leistungsendstufe als fehlerfrei erkannt wird, wenn alle am Sternpunkt gemessenen Spannungen innerhalb des jeweiligen Toleranzbereichs liegen.

Je nach Anforderungen im Einzelnen kann dabei auch vorgesehen sein, dass die Steuereinrichtung mit weiteren Fensterkomparatoren verbunden ist, denen Ausgangsspannungen der Halbbrücken zuführbar sind.

Um bei abgeschalteten Halbleiterschaltern eine reproduzierbare Spannung am Sternpunkt sicherzustellen, können bei der erfindungsgemäßen Anordnung Mittel vorgesehen sein, welche bewirken, dass bei nicht leitenden Halbleiterschaltern die Spannung am Sternpunkt in einem vorgegebenen mittleren Toleranzbereich liegt.

Vorzugsweise ist diese Weiterbildung derart ausgestaltet, dass die Mittel von mindestens einem Widerstand gebildet sind, der zwischen dem Ausgang mindestens einer der Halbbrücken und der Betriebsspannungsquelle liegt und zusammen mit einem weiteren Widerstand, der zwischen dem Ausgang und Masse liegt, eine Spannung im mittleren Toleranzbereich erzeugt.

Eine andere Weiterbildung der erfindungsgemäßen Anordnung verhindert den Einfluss einer schwankenden Betriebsspannung auf das Prüfergebnis dadurch, dass die Betriebsspannung zu Vergleichsmessungen einem Eingang des Fensterkomparators zuführbar ist.

Eine Prüfung ohne eine Überlastung der Leistungsendstufe und der Einrichtungen zur Spannungsversorgung ist bei einer Weiterbildung der erfindungsgemäßen Anordnung dadurch möglich, dass in der Zuleitung der Betriebsspannung ein steuerbarer Schalter vorgesehen ist, dem ein Widerstand parallel geschaltet ist, und dass der steuerbare Schalter von der Steuereinrichtung steuerbar ist. Alternativ kann bei der erfindungsgemäßen Anordnung vorgesehen sein, dass die zur Prüfung dienenden Impulse derart kurz sind, dass sowohl keine Überlastung der Halbleiterschalter stattfindet als auch der Verbraucher während der Prüfung nicht oder nur unmerklich beeinflusst wird.

Die Erfindung kann auch derart weitergebildet werden, dass die Zuführungen zu den Wicklungen mit Hilfe von weiteren steuerbaren Schaltern auftrennbar sind und dass die Prüfung bei geschlossenen und offenen weiteren Schaltern erfolgt. Dabei ist vorzugsweise vorgesehen, dass die weiteren Schalter im Sternpunkt und in den Zuleitungen von den Ausgängen der Halbbrücken zu den Wicklungen angeordnet sind. Damit können noch weitere Fehler erfasst werden.

Die Erfindung lässt zahlreiche Ausführungsformen zu. Drei davon sind schematisch in der Zeichnung als Schaltbilder dargestellt und nachfolgend beschrieben. Es zeigt:
- Fig. 1: ein erstes Ausführungsbeispiel,
- Fig. 2: ein zweites Ausführungsbeispiel und
- Fig. 3: ein drittes Ausführungsbeispiel.

Bei den dargestellten Ausführungsbeispielen bilden zwei MOSFETs 1, 2; 3, 4; 5, 6 jeweils eine Halbbrücke 7, 8, 9 mit Ausgängen 10, 11, 12, an die jeweils eine der in Sternschaltung ausgeführten Wicklungen 13, 14, 15 eines Motors angeschlossen ist. Einem Eingang 16 wird die Betriebsspannung Ubat zugeführt, die als U+ über ein Relais 17 der Leistungsendstufe zugeführt wird. Parallel zu dem Relais 17 liegt ein Strombegrenzungswiderstand 18, über den ein Elektrolyt-Kondensator 19 hoher Kapazität aufgeladen werden kann, wobei das Relais erst eingeschaltet wird, wenn die Spannung U+ etwa der Spannung Ubat entspricht. Damit wird ein unzulässig hoher Ladestromstoß vermieden. Einzelheiten zu dieser bekannten Schaltung sind in DE 100 57 156 A1 ausgeführt.

Die Anordnung umfasst ferner eine Steuereinrichtung 20, die als solche im Zusammenhang mit Leistungsendstufen bekannt ist, von einem Mikrocomputer oder einem digitalen Signalprozessor gebildet wird und als solche zum Verständnis der Erfindung nicht näher erläutert zu werden braucht. Ausgänge der Steuereinrichtung 20 sind mit einer Ansteuerschaltung 21 verbunden, welche Steuersignale für die MOSFETs 1 bis 6 erzeugt. Mit der Steuereinrichtung 20 sind ferner Analog/DigitalWandler 20' verbunden, denen eine von einem Spannungsteiler 22 aus der Betriebsspannung erzeugte Spannung und über eine Pegelanpassung 29 eine Spannung vom Sternpunkt 28 zuführbar sind.

Von einem im Steuergerät 20 vorhandenen Programm wird nun die Prüfung wie folgt gesteuert: Zunächst erfolgt keine Ansteuerung der MOSFETs 1 bis 6, wobei der Ausgang 10 über die Widerstände 26, 30 mit der halben Betriebsspannung U+ beaufschlagt ist. Die Spannung am Sternpunkt 28 wird dann unter der Berücksichtigung der Pegelanpassung 29, die von einem Spannungsteiler realisiert sein kann, geprüft. Liegt die Spannung ebenfalls bei der halben Betriebsspannung U+, konnte bei dieser ersten Prüfung kein Fehler festgestellt werden. Daraus kann bereits geschlossen werden, dass in weiten Bereichen der Endstufe sowie des Motors kein Kurzschluss vorliegt. Liegt jedoch die Spannung am Sternpunkt 28 oberhalb oder unterhalb des mittleren Toleranzbereichs, so kann auf einen Schluss oder einen Fehlerstrom in Richtung U+ bzw. Masse geschlossen werden.

In der folgenden Prüfung werden nacheinander die MOSFETs 1, 3, 5 in den leitenden Zustand geschaltet und geprüft, ob dann Spannung am Sternpunkt einen Wert in einem oberen Toleranzbereich einnimmt - das heißt nahe der Betriebsspannung U+. Bei weiteren Prüfungen werden dann die MOSFETs 2, 4, 6 kurzzeitig in den leitenden Zustand geschaltet. Dabei wird überprüft, ob die Spannung am Sternpunkt 28 in einen unteren Toleranzbereich gerät - also nahe bei 0 Volt liegt.

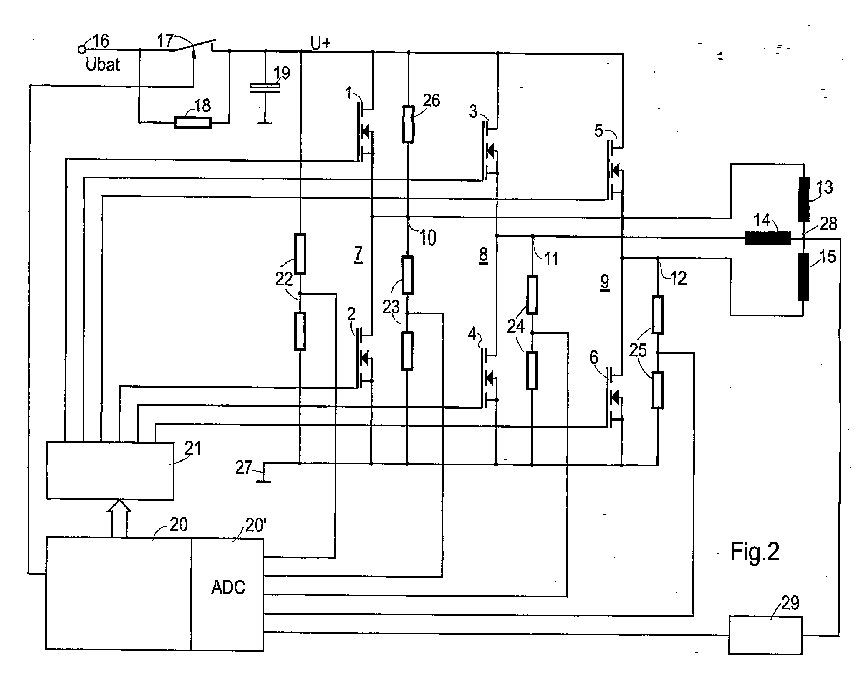

Bei dem Ausführungsbeispiel gemäß Fig. 2 sind die Ausgänge 11, 12 ebenfalls mit Spannungsteilern 23, 24, 25 versehen, deren Ausgangsspannung Analog/Digital-Wandlern 20' zugeführt wird. Die Spannungsteiler weisen wesentlich höhere Widerstandswerte als die Wicklungen 13, 14, 15 auf, um den Wirkungsgrad der Endstufe im Betrieb nicht zu verschlechtern. Damit können außer der Spannung am Sternpunkt die Ausgangsspannungen der Halbbrücken zur Prüfung verwendet werden.

Dem MOSFET 1 ist ein Widerstand 26 parallel geschaltet, der zusammen mit dem Spannungsteiler 23 bewirkt, dass am Ausgang 10 der Halbbrücke 7 im Falle von nicht leitenden MOSFETs 1, 2 die Hälfte der Spannung U+ anliegt.

Die Spannungsteiler 22 bis 25 sind derart ausgelegt, dass bei dem höchst möglichen Wert von U+ die zulässige Spannung von CMOS-Schaltungen nicht überschritten wird. Die vom Spannungsteiler 22 erzeugte Spannung dient für die folgenden beschriebenen einzelnen Prüfungen als Spannungsreferenz zur Bildung der Toleranzbereiche.

Bei der ersten Prüfung folgt keine Ansteuerung der MOSFETs 1 bis 6, so dass der Ausgang 10 die Spannung U+/2 führt, was in der Steuereinrichtung 20 unter Berücksichtigung einer vorgegebenen Toleranz überprüft wird. Ist dieses der Fall, kann daraus geschlossen werden, dass in den MOSFETs 1, 2 und in der Zuleitung zur Wicklung 13 kein Kurzschluss gegen Masse 27 oder Betriebsspannung U+ vorliegt. Bei fehlerfreier Leistungsendstufe sind bei dieser ersten Prüfung auch die MOSFETs 3 bis 6 nicht leitend, so dass über die Wicklungen 13 bis 15 des Motors die Spannungen an den Ausgängen 11, 12 ebenfalls in dem mittleren Toleranzbereich liegen, was von der Steuereinrichtung 20 geprüft wird.

Bei einer zweiten Prüfung werden nacheinander die "oberen" MOSFETs 1, 3, 5 in den leitenden Zustand geschaltet und dabei jeweils überprüft, ob die Ausgänge 10, 11, 12 eine Spannung annehmen, die in einem oberen Toleranzbereich, also in der Nähe der Spannung U+ liegt. Bei einer dritten Prüfung werden die "unteren" MOSFETs 2, 4, 6 nacheinander in den leitenden zustand gebracht. Dabei wird jeweils überprüft, ob die Spannung an den Ausgängen 10, 11, 12 im unteren Toleranzbereich, also verglichen mit U+, in der Nähe des Massepotentials liegt. Aus der Größe der Überschreitung bzw. Unterschreitung des jeweiligen Toleranzbereichs kann auf die Art des Defekts, beispielsweise Kurzschluss oder Überlastung, geschlossen werden.

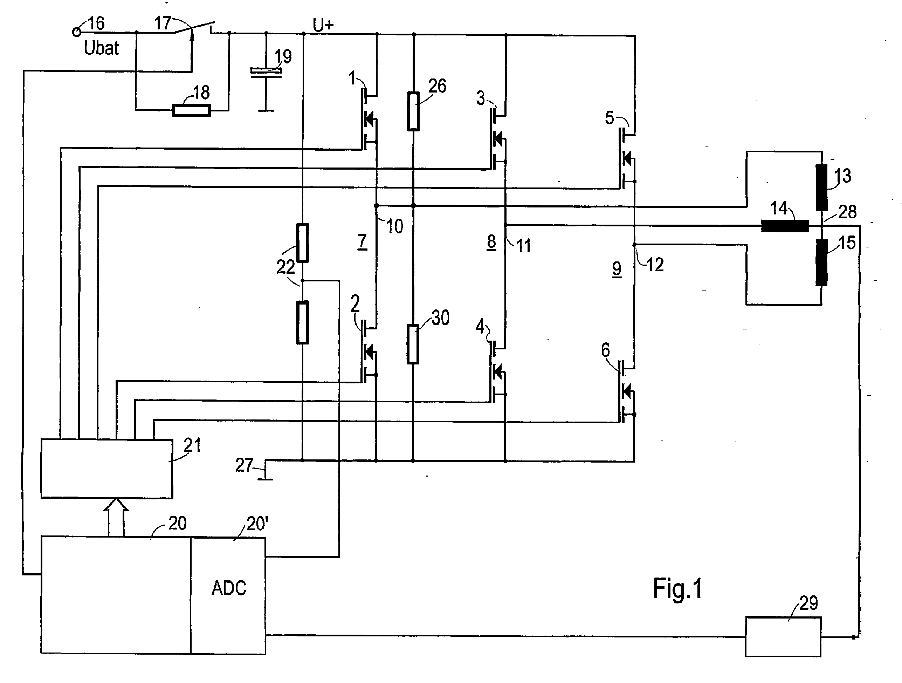

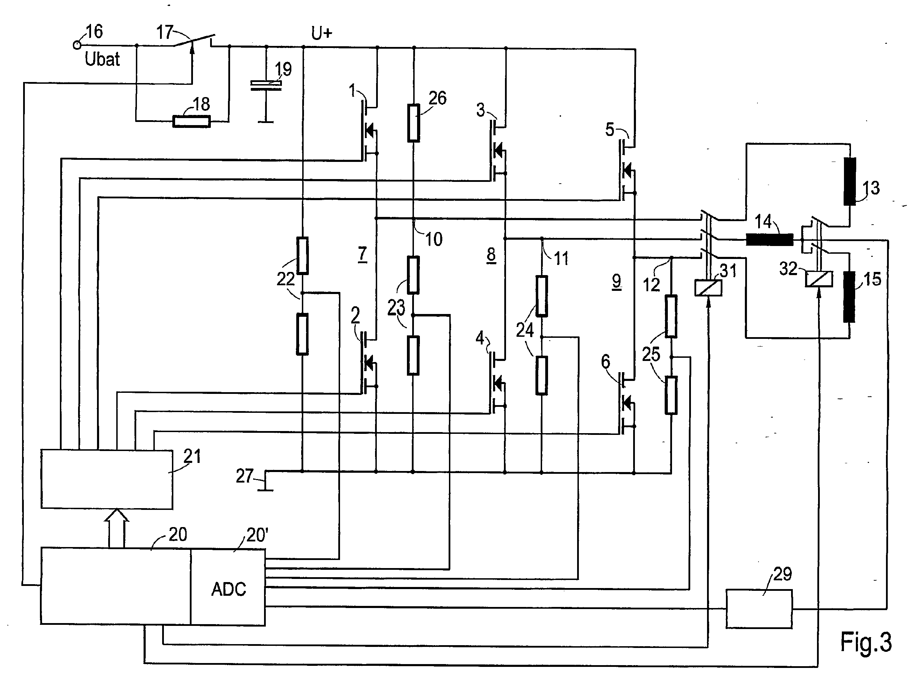

Bei dem Ausführungsbeispiel nach Fig. 3 sind zusätzlich zwei Relais 31, 32 vorgesehen. Das eine 31 dient zum Auftrennen der Zuleitungen zu den Wicklungen 13, 14, 15, während das andere 32 den Sternpunkt auftrennt. Beide Relais werden vom Steuergerät 20 derart gesteuert, dass durch das im Zusammenhang mit den Figuren 1 und 2 beschriebene Schalten der Halbleiterschalter 1 bis 6 und Messen der einzelnen Spannungen noch weitere Fehler erfasst werden können, unter anderem auch die Funktion der Relais 31, 32.

## Patentansprüche

1. Verfahren zur Prüfung einer Leistungsendstufe, wobei die Leistungsendstufe mindestens drei aus jeweils einer Reihenschaltung eines oberen und eines unteren Halbleiterschalters (1, 3, 5; 4, 5, 6) bestehende und mit Betriebsspannung beaufschlagte Halbbrücken (7, 8, 9) aufweist und wobei die Verbindungspunkte der Halbleiterschalter der Halbbrücken Ausgänge (10, 11, 12) bilden, welche mit in Sternschaltung betriebenen Wicklungen (13, 14, 15) eines mindestens dreiphasigen Motors verbunden sind, **dadurch gekennzeichnet, dass** von einer Steuereinrichtung (20) die Halbleiterschalter (1, 3, 5; 4, 5, 6) nacheinander und/oder mehrere gleichzeitig jeweils kurzzeitig in den leitenden Zustand geschaltet werden und dabei die Spannung am Sternpunkt (28) daraufhin überprüft wird, ob sie in einem jeweils vorgegebenen Toleranzbereich liegt, und dass die Leistungsendstufe als fehlerfrei erkannt wird, wenn alle am Sternpunkt (28) gemessenen Spannungen innerhalb des jeweiligen Toleranzbereichs liegen.

2. Verfahren nach Anspruch 1, **dadurch gekennzeichnet, dass** vor und während der Prüfungen die Betriebsspannung über eine strombegrenzende Einrichtung zugeführt wird und dass nach Erkennen der Leistungsendstufe als fehlerfrei die Betriebsspannung ohne Strombegrenzung zugeführt wird.

3. Verfahren nach Anspruch 1, **dadurch gekennzeichnet, dass** während der Prüfung die Halbleiterschalter (1, 3, 5; 4, 5, 6) derart kurzzeitig in den leitenden Zustand geschaltet werden, dass sowohl keine Schäden auftreten als auch der Verbraucher während der Prüfung nicht oder nur unmerklich beeinflusst wird, und dass nach Erkennen der Leistungsendstufe als fehlerfrei den Halbleiterschaltern (1, 3, 5; 4, 5, 6) die für den normalen Betrieb vorgesehenen Ansteuerimpulse zugeführt werden.

4. Verfahren nach einem der vorhergehenden Ansprüche, **dadurch gekennzeichnet, dass** ferner Ausgangsspannungen der Halbbrücken (7, 8, 9) auf ihre Lage innerhalb eines jeweiligen Toleranzbereichs überprüft werden.

5. Verfahren nach einem der vorhergehenden Ansprüche, **dadurch gekennzeichnet,**
- **dass** zunächst eine Prüfung bei nicht in den leitenden Zustand gesteuerten Halbleiterschaltern (1, 3, 5; 4, 5, 6) daraufhin erfolgt, ob die Spannung am Sternpunkt (28) innerhalb eines mittleren Toleranzbereichs liegt,
- **dass** die oberen Halbleiterschalter (1, 3, 5) kurz einzeln nacheinander und/oder mehrere gleichzeitig in den leitenden Zustand geschaltet werden und eine Prüfung daraufhin erfolgt, ob die dabei am Sternpunkt (28) anliegenden Spannungen in einem oberen Toleranzbereich liegen, und
- **dass** die unteren Halbleiterschalter (2, 4, 6) kurz einzeln nacheinander und/oder mehrere gleichzeitig in den leitenden Zustand geschaltet werden und eine Prüfung daraufhin erfolgt, ob die dabei am Sternpunkt (28) anliegenden Spannungen in einem unteren Toleranzbereich liegen.

6. Anordnung zur Prüfung einer Leistungsendstufe, wobei die Leistungsendstufe mindestens drei aus jeweils einer Reihenschaltung eines oberen und eines unteren Halbleiterschalters (1, 3, 5; 2, 4, 6) bestehende und mit Betriebsspannung beaufschlagte Halbbrücken (7, 8, 9) aufweist und wobei die Verbindungspunkte der Halbleiterschalter der Halbbrücken Ausgänge (10, 11, 12) bilden, welche mit in Sternschaltung betriebenen Wicklungen (13, 14, 15) eines mindestens dreiphasigen Motors verbunden sind, **dadurch gekennzeichnet, dass** der Sternpunkt (28) mit Eingängen eines Fensterkomparators (20') verbunden ist, der an eine Steuereinrichtung (20) angeschlossen ist, die eine Ansteuerschaltung (21) für die Halbleiterschalter steuert, und dass die Steuereinrichtung (20) mit einem Programm versehen ist, das die Halbleiterschalter (1, 3, 5; 2, 4, 6) nacheinander und/oder mehrere gleichzeitig jeweils kurzzeitig in den leitenden Zustand schaltet und dabei prüft, ob die Spannung am Sternpunkt (28) in einem jeweils vorgegebenen Toleranzbereich liegt, wobei die Prüfung derart eingerichtet ist, dass die Leistungsendstufe als fehlerfrei erkannt wird, wenn alle am Sternpunkt (28) gemessenen Spannungen innerhalb des jeweiligen Toleranzbereichs liegen.

7. Anordnung nach Anspruch 6, **dadurch gekennzeichnet, dass** die Steuereinrichtung (20) mit weiteren Fensterkomparatoren verbunden ist, denen Ausgangsspannungen der Halbbrücken (7, 8, 9) zuführbar sind.

8. Anordnung nach einem der Ansprüche 6 oder 7, **dadurch gekennzeichnet, dass** Mittel vorgesehen sind, welche bewirken, dass bei nicht leitenden Halbleiterschaltern (1, 3, 5; 2, 4, 6) die Spannung am Sternpunkt (28) in einem vorgegebenen mittleren Toleranzbereich liegt.

9. Anordnung nach Anspruch 8, **dadurch gekennzeichnet, dass** die Mittel von mindestens einem Widerstand (26) gebildet sind, der zwischen dem Ausgang (10) mindestens einer der Halbbrücken (7) und der Betriebsspannungsquelle liegt und zusammen mit einem weiteren Widerstand (30), der zwischen dem Ausgang (10) und Masse liegt, eine Spannung im mittleren Toleranzbereich erzeugt.

10. Anordnung nach einem der Ansprüche 6 bis 9, **dadurch gekennzeichnet, dass** die Betriebsspannung zu Vergleichsmessungen einem Eingang des Fensterkomparators (20') zuführbar ist.

11. Anordnung nach einem der Ansprüche 6 bis 10, **dadurch gekennzeichnet, dass** in der Zuleitung der Betriebsspannung ein steuerbarer Schalter (17) vorgesehen ist, dem ein Widerstand (18) parallel geschaltet ist, und dass der steuerbare Schalter (17) von der Steuereinrichtung (20) steuerbar ist.

12. Anordnung nach einem der Ansprüche 6 bis 11, **dadurch gekennzeichnet, dass** die Zuführungen zu den Wicklungen mit Hilfe von weiteren steuerbaren Schaltern auftrennbar sind und dass die Prüfung bei geschlossenen und offenen weiteren Schaltern erfolgt.

13. Anordnung nach Anspruch 12, **dadurch gekennzeichnet, dass** die weiteren Schalter im Sternpunkt und in den Zuleitungen von den Ausgängen der Halbbrücken zu den Wicklungen angeordnet sind.

## Claims

1. Method for testing a power output stage, with the power output stage having at least three half-bridges (7, 8, 9) which in each case comprise a series circuit made up of an upper and a lower semiconductor switch (1, 3, 5; 2, 4, 6) and to which an operating voltage is applied, and with the connection points of the semiconductor switches of the half-bridges forming outputs (10, 11, 12) which are connected to windings (13, 14, 15), which are operated in a manner connected in star, of an at least three-phase motor, **characterized in that** the control device (20) switches the semiconductor switches (1, 3, 5; 2, 4, 6) to the on state one after the other and/or in each case briefly switches a plurality of semiconductors switches to the on state at the same time and in the process checks whether the voltage at the star point (28) is in a respectively prespecified tolerance range, and **in that** the power output stage is identified as being fault-free when all voltages measured at the star point (28) are within the respective tolerance range.

2. Method according to Claim 1, **characterized in that** the operating voltage is fed via a current-limiting device before and during the tests, and **in that** the operating voltage is fed without the current being limited after the power output stage is identified as being fault-free.

3. Method according to Claim 1, **characterized in that** the semiconductor switches (1, 3, 5; 2, 4, 6) are briefly switched to the on state during the test in such a way that damage does not occur and the load is not influenced or is only inappreciably influenced during the test, and **in that** the drive pulses which are provided for normal operation are fed to the semiconductor switches (1, 3, 5; 2, 4, 6) after the power output stage is identified as being fault-free.

4. Method according to one of the preceding claims, **characterized in that** the position of the output voltages of the half-bridges (7, 8, 9) within a respective tolerance range is also checked.

5. Method according to one of the preceding claims, **characterized**
- **in that**, when the semiconductor switches (1, 3, 5; 2, 4, 6) are not in the on state, a test is first performed to determine whether the voltage at the star point (28) is within an average tolerance range,
- **in that** the upper semiconductor switches (1, 3, 5) are briefly individually switched to the on state one after the other and/or a plurality of upper semiconductor switches are switched to the on state at the same time and a test is performed to determine whether the voltages applied to the star point (28) in the process are in an upper tolerance range, and
- **in that** the lower semiconductor switches (2, 4, 6) are briefly individually switched to the on state one after the other and/or a plurality of lower semiconductor switches are switched to the on state at the same time and a test is performed to determine whether the voltages applied to the star point (28) in the process are in a lower tolerance range.

6. Arrangement for testing a power output stage, with the power output stage having at least three half-bridges (7, 8, 9) which in each case comprise a series circuit made up of an upper and a lower semiconductor switch (1, 3, 5; 2, 4, 6) and to which an operating voltage is applied, and with the connection points of the semiconductor switches of the half-bridges forming outputs (10, 11, 12) which are connected to windings (13, 14, 15), which are operated in a manner connected in star, of an at least three-phase motor, **characterized in that** the star point (28) is connected to inputs of a window comparator (20') which is connected to a control device (20) which controls a drive circuit (21) for the semiconductor switches, and **in that** the control device (20) is provided with a program which switches the semiconductor switches (1, 3, 5; 2, 4, 6) to the on state one after the other and/or in each case briefly switches a plurality of semiconductor switches to the on state at the same time and in the process tests whether the voltage at the star point (28) is in a respectively predefined tolerance range, with the test being designed in such a way that the power output stage is identified as being fault-free when all the voltages measured at the star point (28) are within the respective tolerance range.

7. Arrangement according to Claim 6, **characterized in that** the control device (20) is connected to further window comparators to which output voltages from the half-bridges (7, 8, 9) can be fed.

8. Arrangement according to either of Claims 6 and 7, **characterized in that** means are provided which have the effect that, when the semiconductor switches (1, 3, 5; 2, 4, 6) are not on, the voltage at the star point (28) is in a predefined average tolerance range.

9. Arrangement according to Claim 8, **characterized in that** the means are formed by at least one resistor (26) which is situated between the output (10) of at least one of the half-bridges (7) and the operating voltage source and, together with a further resistor (30) which is situated between the output (10) and earth, generates a voltage in the average tolerance range.

10. Arrangement according to one of Claims 6 to 9, **characterized in that** the operating voltage can be fed to an input of the window comparator (20') for comparison measurements.

11. Arrangement according to one of Claims 6 to 10, **characterized in that** a controllable switch (17) is provided in the feed line of the operating voltage and a resistor (18) is connected in parallel with the said controllable switch, and **in that** the controllable switch (17) can be controlled by the control device (20).

12. Arrangement according to one of Claims 6 to 11, **characterized in that** the feeds to the windings can be disconnected with the aid of further controllable switches, and **in that** the test is performed when the further switches are closed and open.

13. Arrangement according to Claim 12, **characterized in that** the further switches are arranged at the star point and in the feed lines from the outputs of the half-bridges to the windings.

## Revendications

1. Procédé permettant de tester un étage de sortie de puissance, où l'étage de sortie de puissance comporte au moins trois demi-ponts (7, 8, 9) composés chacun d'un montage en série d'un commutateur transistorisé supérieur et d'un commutateur transistorisé inférieur (1, 3, 5; 2, 4, 6) et alimentés en tension de service et où les points de liaison des commutateurs transistorisés des demi-ponts forment des sorties (10, 11, 12), lesquelles sont reliées à des enroulements (13, 14, 15) exploités en montage en étoile dans un moteur au moins triphasé, **caractérisé par le fait que** les commutateurs transistorisés (1, 3, 5; 2, 4, 6) sont commutés brièvement dans leur état conducteur, l'un après l'autre et/ou plusieurs au même moment, et que, simultanément, on contrôle si la tension au point milieu (28) de l'étoile reste comprise dans une plage de tolérance donnée pour chaque cas et que l'étage de sortie de puissance est considéré comme étant sans défaut lorsque toutes les tensions mesurées au point milieu (28) de l'étoile se trouvent à l'intérieur de la plage de tolérance respective.

2. Procédé selon la revendication 1, **caractérisé par le fait que**, avant et pendant les tests, la tension de service est appliquée à travers un dispositif limitateur de l'intensité du courant et que, après avoir constaté que l'étage de sortie de puissance est sans défaut, la tension de service est appliquée sans limitation d'intensité.

3. Procédé selon la revendication 1, **caractérisé par le fait que**, pendant le test, les commutateurs transistorisés (1, 3, 5; 2, 4, 6) sont commutés brièvement dans leur état conducteur de telle manière que non seulement aucune détérioration ne se produit, mais aussi que le consommateur n'est pas influencé ou seulement influencé d'une manière insignifiante pendant le test, et que, après avoir constaté que l'étage de sortie de puissance est sans défaut, les impulsions de commande prévues pour le service normal sont appliquées aux commutateurs transistorisés (1, 3, 5; 2, 4, 6).

4. Procédé selon l'une des revendications précédentes, **caractérisé par le fait que**, en outre, on contrôle quelle est la position des tensions de sortie des demi-ponts (7, 8, 9) dans la plage respective de tolérance.

5. Procédé selon l'une des revendications précédentes, **caractérisé par le fait**
- **qu'**on exécute d'abord un test avec les commutateurs transistorisés (1, 3, 5; 2, 4, 6) non commutés dans leur état conducteur pour contrôler si la tension au point milieu (28) de l'étoile se trouve dans une plage de tolérance moyenne,
- **qu'**on commute dans leur état conducteur les commutateurs transistorisés supérieurs (1, 3, 5) brièvement séparément l'un après l'autre et/ou plusieurs au même moment et qu'on contrôle si les tensions qui existent alors au point milieu (28) de l'étoile se trouvent dans une plage de tolérance supérieure et
- **qu'**on commute dans leur état conducteur les commutateurs transistorisés inférieurs (2, 4, 6) brièvement séparément l'un après l'autre et/ou plusieurs au même moment et qu'on contrôle si les tensions qui existent alors au point milieu (28) de l'étoile se trouvent dans une plage de tolérance inférieure.

6. Dispositif permettant de tester un étage de sortie de puissance, où l'étage de sortie de puissance comporte au moins trois demi-ponts (7, 8, 9) composés chacun d'un montage en série d'un commutateur transistorisé supérieur et d'un commutateur transistorisé inférieur (1, 3, 5; 2, 4, 6) et alimentés en tension de service et où les points de liaison des commutateurs transistorisés des demi-ponts forment des sorties (10, 11, 12), lesquelles sont reliées à des enroulements (13, 14, 15) exploités en montage en étoile dans un moteur au moins triphasé, **caractérisé par le fait que** le point milieu (28) de l'étoile est relié à des entrées d'un comparateur à fenêtre (20'), lequel est raccordé à un dispositif de commande (20) qui commande un circuit d'excitation (21) pour les commutateurs transistorisés, et que le dispositif de commande (20) est doté d'un programme qui commute brièvement dans leur état conducteur les commutateurs transistorisés (1, 3, 5; 2, 4, 6), l'un après l'autre et/ou plusieurs au même moment, et que, simultanément, on contrôle si la tension au point milieu (28) de l'étoile reste comprise dans une plage de tolérance donnée pour chaque cas, le test étant conçu de manière telle que l'étage de sortie de puissance est considéré comme étant sans défaut lorsque toutes les tensions mesurées au point milieu (28) de l'étoile se trouvent à l'intérieur de la plage de tolérance respective.

7. Dispositif selon la revendication 6, **caractérisé par le fait que** le dispositif de commande (20) est relié à d'autres comparateurs à fenêtre auxquels il est possible d'appliquer des tensions de sortie des demi-ponts (7, 8, 9).

8. Dispositif selon l'une des revendications 6 ou 7, **caractérisé par le fait qu'**il est prévu des moyens qui ont pour effet que, lorsque les commutateurs transistorisés (1, 3, 5; 2, 4, 6) ne sont pas dans leur état conducteur, la tension au point milieu (28) de l'étoile se trouve dans une plage de tolérance moyenne donnée.

9. Dispositif selon la revendication 8, **caractérisé par le fait que** les moyens sont constitués par au moins une résistance (26), qui se trouve entre la sortie (10) de l'un au moins des demi-ponts (7) et la source de tension de service, et qui produit, en commun avec une autre résistance (30), qui se trouve entre la sortie (10) et la masse, une tension se trouvant dans la plage de tolérance moyenne.

10. Dispositif selon l'une des revendications 6 à 9, **caractérisé par le fait que** la tension de service peut être appliquée, pour des mesures de comparaison, à une entrée du comparateur à fenêtre (20').

11. Dispositif selon l'une des revendications 6 à 10, **caractérisé par le fait qu'**il est prévu, sur le conducteur d'alimentation de la tension de service, un commutateur contrôlé (17), sur lequel est montée une résistance (18) en parallèle, et que le commutateur contrôlé (17) peut être commandé par le dispositif de commande (20).

12. Dispositif selon l'une des revendications 6 à 11, **caractérisé par le fait que** les conducteurs allant vers les enroulements peuvent être interrompus par d'autres commutateurs contrôlés et que le test est effectué alors que les autres commutateurs sont fermés et ouverts.

13. Dispositif selon la revendication 12, **caractérisé par le fait que** les autres commutateurs sont disposés au point milieu de l'étoile et sur les conducteurs conduisant des sorties des demi-ponts vers les enroulements.
